# EUROPÄISCHE PATENTANMELDUNG

(11) **EP 2 963 680 A1**
(43) Veröffentlichungstag der Anmeldung: **06.01.2016**
(21) Anmeldenummer: 14175236.0
(22) Anmeldetag: 01.07.2014
(51) Int. Cl.: H01L 23/40, H01L 23/367

(54) **Elektronikbaugruppe mit einem Kühlkörper**

(71) Anmelder: Siemens Aktiengesellschaft, 80333 München (DE)
(72) Erfinder: Bräunlich, Michael, 09117 Chemnitz (DE); Ott, Thomas, 09131 Chemnitz (DE); Pohl, Daniel, 09127 Chemnitz (DE); Rochlitzer, Daniela, 09114 Chemnitz (DE)

(57) **Zusammenfassung**

Die Erfindung betrifft eine Elektronikbaugruppe (100) aufweisend
- eine Leiterplatte (1),
- ein auf der Leiterplatte (1) angeordnetes zu kühlendes elektrisches Bauteil (2),
- einen Kühlkörper (3),

wobei der Kühlkörper (3) derart auf dem elektrischen Bauteil (2) angeordnet ist, das ein das Bauteil (2) erzeugter Wärmestrom in den Kühlkörper (3) geführt wird,
wobei zumindest ein erstes elektrisch leitendes Befestigungselement (11) und ein zweites elektrisch leitendes Befestigungselement (12) derart in der Leiterplatte (1) eingearbeitet ist, dass die Befestigungselemente (11,12) elektrisch leitend mit einer die Leiterplatte (1) aufweisenden Massebahn (4) verbunden sind, wobei der Kühlkörper (3) zumindest ein erstes Klemmmittel (21) und ein zweites Klemmmittel (22) aufweist, die Befestigungselemente (11,12) stiftförmig ausgeprägt sind und bei auf das Bauteil (2) aufgesetztem Kühlkörper (3) innerhalb der Klemmmittel (21,22) angeordnet sind und mit diesen elektrisch leitend verbunden sind.

## Beschreibung

Die Erfindung geht aus von einer Anordnung zum Kühlen eines auf einer Leiterplatte angeordneten Bauelementes.

Zum Kühlen eines elektrischen Bauelementes ist es bekannt, einen Kühlkörper vorzusehen, der thermisch mit dem Bauelement gekoppelt ist. Der Kühlkörper ist in der Form und Größe dem Bauelement bzw. der abzuführenden Wärme angepasst.

Insbesondere in Automatisierungssystemen für die Automatisierung industrieller Prozesse werden in Automatisierungskomponenten und/oder Elektronikbaugruppen häufig Bauelemente eingesetzt, die zur Sicherstellung der Funktionsfähigkeit eine Kühlung erhalten müssen. Diese Kühlung bzw. Kühlanordnung ist in der Prozessautomatisierung von besonderer Wichtigkeit, da in der Umgebung von Prozessautomatisierungssystemen erschwerte Umweltbedingungen, wie erhöhte Umgebungstemperaturen existieren.

Aus dem allgemeinen Fachwissen ist bekannt, dass der Kühlkörper in der Regel mittels Verschraubungen, vorzugsweise vier Schrauben, auf die Leiterplatte geschraubt wird.

Es ist Aufgabe der vorliegenden Erfindung bei der Montage einer Elektronikbaugruppe die Anzahl der zu verbauenden Teile und die Arbeitsschritte zu verringern, wodurch die Montage vereinfacht wird.

Die Aufgabe wird durch eine Elektronikbaugruppe aufweisend eine Leiterplatte, ein auf der Leiterplatte angeordnetes zu kühlendes elektrisches Bauteil, einen Kühlkörper, wobei der Kühlkörper derart auf dem elektrischen Bauteil angeordnet ist, dass an das Bauteil erzeugter Wärmestrom in den Kühlkörper geführt wird, dadurch gelöst, dass zumindest ein erstes elektrisch leitendes Befestigungselement und ein zweites elektrisch leitendes Befestigungselement derart in der Leiterplatte eingearbeitet ist, dass die Befestigungselemente elektrisch leitend mit einer die Leiterplatte aufweisenden Massebahn verbunden sind, wobei der Kühlkörper zumindest ein erstes Klemmmittel und ein zweites Klemmmittel aufweist, die Befestigungselemente stiftförmig ausgeprägt sind und bei auf das Bauteil aufgesetztem Kühlkörper innerhalb der Klemmmittel angeordnet sind und mit diesem elektrisch leitend verbunden sind.

Durch das Vorsehen der Klemmmittel werden die Anzahl der zu verbauenden Teile und die Anzahl der auszuführenden Arbeitsschritte bei der Montage der Elektronikbaugruppe vereinfacht. Insbesondere im Hinblick auf eine erhöhte Störfestigkeit im Hinblick auf elektromagnetische Einstrahlungen oder Abstrahlungen der Baugruppe ist es von Vorteil, wenn der auf das elektrische Bauteil aufgebrachte Kühlkörper eine dauerhafte elektrische Verbindung zu einer Massebahn und/oder zu einer Funktionserde der Elektronikbaugruppe aufweist. Eine elektrische Verbindung des Kühlkörpers zu der Massebahn der Leiterplatte wird durch eine definierte Klemmkraft der Klemmmittel auf die stiftförmig ausgeprägten Befestigungselemente gewährleistet. Damit übernimmt der auf dem elektrischen Bauteil angeordnete Kühlkörper zwei Funktionen. Zum einen wird das elektrische Bauteil gekühlt und zum anderen wirkt der Kühlkörper als ein Schirmblech für das elektrische Bauteil, wobei das Schirmblech eine Aussendung von Störstrahlen verhindert bzw. ein Einkoppeln von Störstrahlen in das elektrische Bauteil unterdrückt.

Damit eine Prüfung der Lötstellen des elektrischen Bauteiles auf der Leiterplatte, beispielsweise mit einer Röntgentechnik, durchgeführt werden kann, darf der Kühlkörper erst nach der Montage des elektrischen Bauteils, z.B. einem ASIC, aufgebracht werden. Auch hier bietet das Aufklemmen des Kühlkörpers nach der Montage des elektrischen Bauteils einen Vorteil.

Vorteilhafter Weise können die Klemmmittel als eine Klemmscheibe ausgebildet sein.

In einer alternativen Ausgestaltung des Kühlkörpers sind die Klemmmittel als ein integrativer Bestandteil des Kühlkörpers ausgebildet.

Dabei ist es weiterhin von Vorteil, wenn der Kühlkörper mit dem Klemmmittel einstückig als ein Stanzbiegeteil ausgebildet ist. Ein einstückiges Stanzbiegeteil verringert erheblich die Produktionskosten eines Kühlkörpers.

Mit Vorteil ist der Kühlkörper im Wesentlichen rechteckig ausgebildet und in einer ersten Ecke ist das erste Klemmmittel, in einer zweiten Ecke das zweite Klemmmittel, in einer dritten Ecke ein drittes Klemmmittel und in einer vierten Ecke ein viertes Klemmmittel angeordnet. Durch diese Ausgestaltung des Kühlkörpers kann im Hinblick auf eine Stanzbiegetechnik in annähernd zwei Arbeitsschritten der Kühlkörper auf einfache Art und Weise hergestellt werden.

Um ein rasches und einfaches Aufklemmen des Kühlkörpers auf das elektrische Bauteil zu gewährleisten, weisen die Klemmmittel zumindest eine erste Lasche und eine zweite Lasche auf, wobei die Laschen zwischen einem ersten Schlitz und einem zweiten Schlitz derart angeordnet sind, dass ein erstes Laschenende der ersten Lasche einem zweiten Laschenende der zweiten Lasche in einem Abstand gegenübersteht, wobei die erste Lasche und die zweite Lasche aus einer flächigen Ebene der jeweiligen Ecken derart herausgebogen sind, dass eine Federwirkung in der Lasche entsteht, wobei die stiftförmigen Befestigungselemente zwischen den jeweiligen ersten und zweiten Laschenenden angeordnet sind. Durch das Herausbiegen der Laschen mit der dadurch entstehenden Federwirkung hat nach einer Montage des Kühlkörpers auf den Befestigungselementen der Kühlkörper einen festen und sicheren Halt auf dem elektrischen Bauteil.

Der Halt des Kühlkörpers wird weiter verbessert, wenn die Laschen jeweils in den Laschenenden eine Kerbe aufweisen.

Der mechanische Halt des Kühlkörpers kann noch um ein weiteres verbessert werden, wenn die stiftförmigen Befestigungselemente auf ihrer Mantelfläche Verrastrippen aufweisen.

Eine Kühlung des elektrischen Bauteils kann dadurch optimiert werden, dass bei dem Kühlkörper ausgebildet als einstückiges Stanzbiegeteil eine erste Kühlrippe und eine zweite Kühlrippe im Wesentlichen rechtwinklig zur überwiegend rechteckigen Fläche ausgeprägt angeordnet sind.

Eine weitere mechanische Stabilität wird dadurch erreicht, dass die Ecken durch Abwinkeln eines Überstandes als abgewinkelte Standfüße ausgebildet sind, welche zur Leiterplatte hingerichtet sind.

Ein das Bauteil erzeugter Wärmestrom kann noch besser abgeführt werden, wenn auf dem Kühlkörper ein weiterer Kühlkörper aufgesetzt ist.

Betrachtet man die Montage der Elektronikbaugruppe in einzelnen Montageschritten bzw. Verfahrensschritten, so wird ein weiterer Vorteil des Kühlkörpers mit Klemmmitteln ersichtlich. Als erstes sollten auf der Leiterplatte die Befestigungselemente eingelötet werden, da das Einlöten von Befestigungselementen in der Regel die größte Wärmebelastung für die Leiterplatte und die Leiterbahnen darstellt. Da die elektrischen Bauteile in der Regel sehr empfindlich sind, müssen die elektrischen Bauteile nach dem Einlöten der Befestigungselemente eingelötet werden. Nach dem Einlöten des elektrischen Bauteils oder der elektrischen Bauteile, beispielsweise einer Anzahl von ASICs, kann eine Kontrolle der Lötstellen mit Hilfe einer Röntgentechnik durchgeführt werden. Bei der Kontrolle der Lötstellen mit der Röntgentechnik ist es vorteilhaft, dass der Kühlkörper noch nicht auf dem elektrischen Bauteil angeordnet ist. Nach einer erfolgreichen Prüfung der Lötstellen des elektrischen Bauteils kann mit Hilfe der in dem Kühlkörper angeordneten Klemmmittel und der bereits in einem frühen Verfahrensschritt eingebauten Befestigungselemente der Kühlkörper einfach auf das zu kühlende Bauteil aufgeschoben werden. Aufgrund der vorzugsweise in die Laschenenden eingearbeiteten Kerben und der in den Befestigungselementen vorhandenen Rastrippen wird der Kühlkörper sicher auf das elektrische Bauteil aufgeschoben und verbleibt in seiner endgültigen Position.

Die Zeichnung zeigt ein Ausführungsbeispiel der Elektronikbaugruppe bzw. des Kühlkörpers. Es zeigt
- FIG 1: eine perspektivische Darstellung einer Leiterplatte mit einem Kühlkörper und
- FIG 2: eine perspektivische Darstellung des Kühlkörpers ohne Leiterplatte.

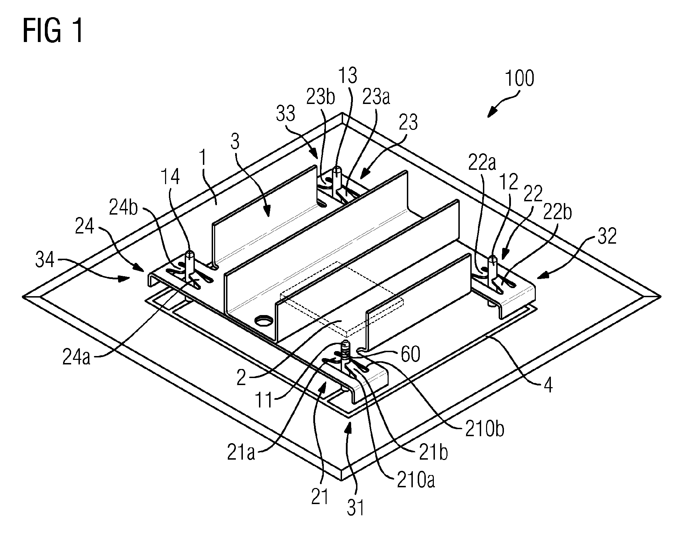

Gemäß FIG 1 ist eine Elektronikbaugruppe 100 aufweisend eine Leiterplatte 1 und ein auf der Leiterplatte 1 angeordnetes zu kühlendes elektrisches Bauteil 2 dargestellt. Das zu kühlende elektrische Bauteil ist gestrichelt dargestellt und soll andeuten, dass es unterhalb eines Kühlkörpers 3 liegt.

Der Kühlkörper 3 ist derart auf dem elektrischen Bauteil 2 angeordnet, dass ein das Bauteil 2 erzeugter Wärmestrom in den Kühlkörper 3 geführt wird.

Der Kühlkörper 3 ist im Wesentlichen rechteckig ausgebildet und in einer ersten Ecke 31 ist ein erstes Klemmmittel 21, in einer zweiten Ecke 32 ist ein zweites Klemmmittel 22, in einer dritten Ecke 33 ist ein drittes Klemmmittel 23 und in einer vierten Ecke 34 ist ein viertes Klemmmittel 24 angeordnet.

Da der Kühlkörper 3 mit den Klemmmitteln 21,22,23,24 einstückig als ein Stanzbiegeteil ausgestaltet ist, sind die Klemmmittel 21,22,23,24 ein integrativer Bestandteil des Kühlkörpers 3 und der Kühlkörper 3 lässt sich dadurch einfach herstellen.

Auf der Leiterplatte 1 sind entsprechend der geometrischen Vorgaben des Kühlkörpers 3 ein erstes Befestigungselement 11, ein zweites Befestigungselement 12, ein drittes Befestigungselement 13 und ein viertes Befestigungselement 14 angeordnet. Im Hinblick auf eine spätere EMV Verträglichkeit bzw. auf eine Erhöhung der Störfestigkeit bezogen auf eine Einstrahlung von Störstrahlen in das elektrische Bauteil 2 oder eine Abstrahlung von Störstrahlen des elektrischen Bauteils 2 sind die Befestigungselemente 11,12,13,14 mit einer die Leiterplatte 1 aufweisenden Massebahn 4 verbunden. Wird der Kühlkörper 3 nach Abschluss aller Lötarbeiten auf die Leiterplatte bzw. auf die Befestigungselemente 11,12,13,14 aufgesteckt, so sind beim aufgesetzten Kühlkörper 3 die stiftförmig ausgeprägten Befestigungselemente 11,12,13,14 innerhalb der Klemmmittel 21,22,23,24 angeordnet.

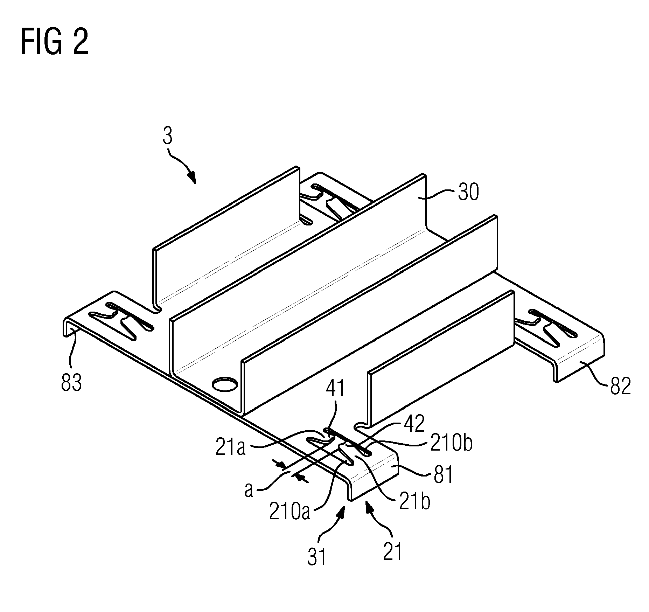

Zum Erreichen eines sicheren mechanischen Haltes des Kühlkörpers 3 auf den Befestigungselementen 11,12,13,14 weisen die Klemmmittel 21,22,23,24 eine erste Lasche 21a und eine zweite Lasche 21b auf, wobei die Laschen 21a,21b zwischen einem ersten Schlitz 210a und einem zweiten Schlitz 210b derart angeordnet sind, dass ein erstes Laschenende 41 (siehe FIG 2) der ersten Lasche 21a einem zweiten Laschenende 42 der zweiten Lasche 21b in einem Abstand a gegenübersteht, wobei die erste Lasche 21a und die zweite Lasche 21b aus einer flächigen Ebene der jeweiligen Ecken 31,32,33,34 derart herausgebogen sind, dass eine Federwirkung der Lasche entsteht, wobei die stiftförmigen Befestigungselemente 11,12,13,14 zwischen den jeweiligen ersten und zweiten Laschenenden 41,42 angeordneten sind.

Die Klemmmittel 21,22,23,24 sind in diesem Beispiel alle identisch aufgebaut, so dass auf eine genaue Beschreibung der einzelnen vier Klemmmittel 21,22,23,24 verzichtet wird und nur exemplarisch die Beschreibung für das erste Klemmmittel 21 bzw. die Laschen 21a und 21b erfolgt.

Mit der FIG 2 ist der Kühlkörper 3 in einer perspektivischen Darstellung abgebildet, wobei auch mit der FIG 2 für die Erklärung des Klemmmittels 21 nur das erste Klemmmittel 21 herangezogen wird.

Zur verbesserten Kühlwirkung ist auf dem Kühlkörper 3 ein weiterer Kühlkörper 30 aufgesetzt. Der weitere Kühlkörper 30 ist ebenfalls als ein einfaches Stanzbiegeteil realisiert. Der Kühlkörper 3 weist eine erste abgewinkelte Kühlrippe 71 und eine zweite abgewinkelte Kühlrippe 72 auf. In Verbindung mit dem aufgesetzten weiteren Kühlkörper 30 besitzt der Kühlkörper 30 nun vier Rippen.

Die Ecken 31,32,33,34 sind durch Abwinkeln eines Überstandes als abgewinkelte Standfüsse 81,82,83,84 ausgebildet, welche zur Leiterplatte 1 hin gerichtet sind.

Das erste Klemmmittel 21 weist die erste Lasche 21a und die zweite Lasche 21b auf. In den jeweiligen Laschenenden 41,42 der ersten Lasche 21a und der zweiten Lasche 21b ist jeweils eine Kerbe 50 angeordnet. Die Laschen 21a,21b sind zwischen einem ersten Schlitz 210a und einem zweiten Schlitz 210b derart angeordnet, dass sie nach einem Stanzen des Kühlkörpers 3 sich leicht aus der flächigen Ebene der jeweiligen Ecken 31 derart herausbiegen lassen, wobei eine Federwirkung der Lasche entsteht, wobei die Federwirkung auf das später zwischen den Laschen befindliche stiftförmige Befestigungselement 11 eine Kraft ausübt. Dadurch, dass die erste Lasche 21a mit dem ersten Laschenende 41 und die zweite Lasche 21b mit dem zweiten Laschenende 42 sich in einem Abstand a gegenüberstehen wird das Befestigungselement 11 durch die Laschen 21a,21b sicher gehalten.

## Patentansprüche

1. Elektronikbaugruppe (100) aufweisend
- eine Leiterplatte (1),
- ein auf der Leiterplatte (1) angeordnetes zu kühlendes elektrisches Bauteil (2),
- einen Kühlkörper (3),
wobei der Kühlkörper (3) derart auf dem elektrischen Bauteil (2) angeordnet ist, dass ein das Bauteil (2) erzeugter Wärmestrom in den Kühlkörper (3) geführt wird,
**dadurch gekennzeichnet, dass** zumindest ein erstes elektrisch leitendes Befestigungselement (11) und ein zweites elektrisch leitendes Befestigungselement (12) derart in der Leiterplatte (1) eingearbeitet ist, dass die Befestigungselemente (11,12) elektrisch leitend mit einer die Leiterplatte (1) aufweisenden Massebahn (4) verbunden sind, wobei der Kühlkörper (3) zumindest ein erstes Klemmmittel (21) und ein zweites Klemmmittel (22) aufweist, die Befestigungselemente (11,12) stiftförmig ausgeprägt sind und bei auf das Bauteil (2) aufgesetztem Kühlkörper (3) innerhalb der Klemmmittel (21,22) angeordnet sind und mit diesen elektrisch leitend verbunden sind.

2. Elektronikbaugruppe (100) nach Anspruch 1, wobei die Klemmmittel (21,22) als eine Klemmscheibe ausgebildet sind.

3. Elektronikbaugruppe (100) nach Anspruch 1, wobei die Klemmmittel (21,22) als ein integrativer Bestandteil des Kühlkörpers (3) ausgebildet sind.

4. Elektronikbaugruppe (100) nach Anspruch 3, wobei der Kühlkörper (3) mit den Klemmmitteln (21,22) einstückig als ein Stanzbiegeteil ausgebildet ist.

5. Elektronikbaugruppe (100) nach Anspruch 4, wobei der Kühlkörper (3) im Wesentlichen rechteckig ausgebildet ist und in einer ersten Ecke (32) das erste Klemmmittel (21), in einer zweiten Ecke (32) das zweite Klemmmittel (22), in einer dritten Ecke (33) ein drittes Klemmmittel (23) und in einer vierten Ecke (34) ein viertes Klemmmittel (24) angeordnet ist.

6. Elektronikbaugruppe (100) nach einem der Ansprüche 3 bis 5, wobei die Klemmmittel (21,22,23,24) zumindest eine erste Lasche (21a) und eine zweite Lasche (21b) aufweisen, wobei die Laschen (21a,21b) zwischen einem ersten Schlitz (210a) und einem zweiten Schlitz (210b) derart angeordnet sind, dass ein erstes Laschenende (41) der ersten Lasche (21a) einem zweiten Laschenende (42) der zweiten Lasche (21b) in einem Abstand (a) gegenübersteht, wobei die erste Lasche (21a) und die zweite Lasche (21b) aus einer flächigen Ebene der jeweiligen Ecken (31,32,33,34) derart herausgebogen sind, dass eine Federwirkung der Lasche (21a,21b) entsteht, wobei die stiftförmigen Befestigungselemente (11,12,13,14) zwischen den jeweiligen ersten und zweiten Laschenenden (41,42) angeordnet sind.

7. Elektronikbaugruppe (100) nach Anspruch 6, wobei die Laschenenden (41,42) jeweils eine Kerbe (50) aufweisen.

8. Elektronikbaugruppe (100) nach einem der Ansprüche 1 bis 7, wobei die stiftförmigen Befestigungselemente (11,12,13,14) auf ihrer Mantelfläche Verrastrippen (60) aufweisen.

9. Elektronikbaugruppe (100) nach einem der Ansprüche 3 bis 8, wobei bei dem einstückigen Stanzbiegeteil eine erste Kühlrippe (71) und eine zweite Kühlrippe (72) im Wesentlichen rechtwinklig zur überwiegend rechteckigen flächigen Ausprägung des Kühlkörpers (3) angeordnet sind.

10. Elektronikbaugruppe (100) nach einem der Ansprüche 3 bis 9, wobei die Ecken (31,32,33,34) durch Abwinkeln eines Überstandes als abgewinkelte Standfüße (81,82,83,84) ausgebildet sind, welche zur Leiterplatte (1) hin gerichtet sind.

11. Elektronikbaugruppe (100) nach einem der Ansprüche 3 bis 10, wobei auf den Kühlkörper (3) ein weiterer Kühlkörper (30) aufgesetzt ist.
